# EUROPEAN PATENT APPLICATION

(11) **EP 4 611 260 A2**
(43) Date of publication of application: **03.09.2025**
(21) Application number: 25154883.0
(22) Date of filing: 30.01.2025
(51) Int. Cl.: H03K 7/00, H04B 10/50, H04J 3/04

(54) **APPARATUS COMPRISING ANALOG MULTIPLEXERS AND METHOD FOR AN APPARATUS COMPRISING ANALOG MULTIPLEXERS**

(30) Priority: 08.02.2024 US 202418436859
(71) Applicant: Nokia Solutions and Networks Oy, 02610 Espoo (FI)
(72) Inventor: THOMAS, Philipp, Scotch Plains, NJ (US)
(74) Representative: Nokia EPO representatives

(57) **Abstract**

An apparatus comprising a first analog multiplexer (110) configured to provide a respective one of a plurality of first input signals (IS1) as a first output signal (OS1) based on a first control signal (CLK1), a second analog multiplexer (120) configured to provide a respective one of a plurality of second input signals (IS2) as a second output signal (OS2) based on a second control signal (CLK2), and a combiner (130) configured to combine the first output signal and the second output signal to obtain a third output signal (OS3).

## Description

### Field of the Disclosure

Various example embodiments relate to an apparatus comprising analog multiplexers.

Further example embodiments relate to a method for an apparatus comprising analog multiplexers.

### Background

In some conventional approaches, optical components used for coherent data signal modulation, e.g. Mach-Zehnder modulators and 90° hybrids, can easily reach physical lengths in the order of centimeters. Besides the material cost that directly increases with physical dimensions, the comparatively large size of such components makes it difficult to package them, e.g., in compact modern form factors.

### Summary

Various example embodiments of the disclosure are set out by the independent claims. The example embodiments and features, if any, described in this specification, that do not fall under the scope of the independent claims, are to be interpreted as examples useful for understanding various example embodiments of the disclosure.

Some examples relate to an apparatus comprising a first analog multiplexer configured to provide a respective one of a plurality of first input signals as a first output signal based on a first control signal, a second analog multiplexer configured to provide a respective one of a plurality of second input signals as a second output signal based on a second control signal, and a combiner configured to combine the first output signal and the second output signal to obtain a third output signal. In some examples, this enables to, e.g., efficiently, aggregate, e.g., interleave, a plurality of input signals, which may, e.g., collectively be characterized by the third output signal.

In some examples, at least one of the first or second analog multiplexer is configured to receive a plurality of analog electrical input signals, e.g., at different input ports, and to provide one of the plurality of analog electrical input signals, e.g., at a time, at an output of the analog multiplexer. In some examples, thus, an analog multiplexer can be considered to connect, e.g., switch, a respective input port to its output port, e.g., based on a respective control signal. In some examples, a switch frequency, which determines a rate for switching different respective input ports to the output port, e.g., one after the other, may be determined by the respective control signal for the analog multiplexer.

In some examples, a round-robin scheme may be employed to control a sequence for the switching of input ports to the output port of an analog multiplexer.

In some examples, an analog electrical input signal is an electrical signal which is continuous at least with respect to a) time, or b) its amplitude. In some examples, an analog electrical input signal may, e.g., be obtained at an output of a digital-to-analog converter.

In some examples, an analog data source may be provided which is configured to provide at least one of a) the first input signals, or b) the second input signals. In some examples, the analog data source may, e.g., comprise a plurality of digital-to-analog converters.

In some examples, the apparatus comprises a signal source configured to provide a first periodic (e.g., electrical) signal as the first control signal and to provide a phase-shifted version of the first periodic signal as the second control signal. In some examples, this enables to interleave, e.g., time interleave, the output signals of the first analog multiplexer and the second analog multiplexer.

In some examples, the apparatus comprises an oscillator, e.g., local oscillator, configured to provide the first periodic signal, and a phase shifter configured to apply a phase shift to the first periodic signal to obtain the phase-shifted version of the first periodic signal, and to output the phase-shifted version of the first periodic signal.

In some examples, the signal source may comprise at least one of the oscillator or the phase shifter.

In some examples, the combiner comprises a phase shifter configured to apply a phase shift to at least one of the first output signal or the second output signal, e.g., prior to the combining. Thus, in some examples, the analog multiplexers may, for example, be controlled with a same, e.g., single, control signal, and a phase shifting enabling to interleave the first and second output signals of the analog multiplexers may be effected by the phase shifter of the combiner.

In some examples, a phase shift between the first control signal and the second control signal is 90 degrees.

In some examples, a switch frequency of the first analog multiplexer and the second analog multiplexer for switching between respective ones of the plurality of first input signals or the plurality of second input signals is equal to or greater than a symbol rate of the first input signals or the second input signals. In some examples, this enables to effectively increase, e.g., double, a symbol rate at a respective output of the analog multiplexers.

In some examples, the apparatus comprises a modulator stage configured to modulate, based on the third output signal, at least one of: a) a wireless carrier, e.g., a radio frequency signal, or b) an optical carrier, e.g., an optical signal such as, e.g., provided by a laser.

In some examples, the modulator stage comprises at least one of: a) a directly modulated laser, or b) a Mach-Zehnder modulator.

In some examples, at least one of a) the first analog multiplexer, or b) the second analog multiplexer is an M:1 multiplexer, wherein M is equal to or greater than 2. In other words, in some examples, at least one of a) the first analog multiplexer, or b) the second analog multiplexer may comprise M many inputs, e.g., input ports, which may, e.g., selectively, be connected, e.g. switched, to the output port of the respective analog multiplexer, e.g., as controlled by a respective first or second control signal.

In some examples, the apparatus is configured to time interleave 2*M many input signals, wherein M characterizes a respective number of inputs of the first analog multiplexer and the second analog multiplexer. Hence, in some examples, M many I/Q-modulated analog input signals, each comprising an in-phase (e.g., "I"-) component and a quadrature phase (e.g., "Q"-) component, may be interleaved using the apparatus according to the disclosure, e.g., to form the third output signal.

Some examples relate to a method for an apparatus comprising a first analog multiplexer, a second analog multiplexer, and a combiner, e.g., for an apparatus according to the disclosure, the method comprising: providing, by means of the first analog multiplexer, a respective one of a plurality of first input signals as a first output signal based on a first control signal, providing, by means of the second analog multiplexer, a respective one of a plurality of second input signals as a second output signal based on a second control signal, combining, by means of the combiner, the first output signal and the second output signal to obtain a third output signal.

Some examples relate to an apparatus comprising means for: providing a respective one of a plurality of first input signals as a first output signal based on a first control signal, providing a respective one of a plurality of second input signals as a second output signal based on a second control signal, combining the first output signal and the second output signal to obtain a third output signal.

Some examples relate to a transmitter comprising at least one apparatus according to the disclosure. In some examples, the transmitter may be an optical transmitter, e.g., configured to transmit at least one modulated optical signal. In some examples, the transmitter may be a radio transmitter, e.g., configured to transmit at least one modulated radio signal, e.g., in a radio frequency range.

Some examples relate to an apparatus comprising a first analog de-multiplexer configured to provide, based on a first de-multiplexer control signal, a respective portion of a modulated signal at a respective output of the first analog de-multiplexer, a second analog de-multiplexer configured to provide, based on a second de-multiplexer control signal, a respective portion of the modulated signal at a respective output of the second analog de-multiplexer. In some examples, the modulated signal may, e.g., be the third output signal as provided by the apparatus according to the disclosure or a signal derived from the third output signal.

In some examples, a phase shift between the first de-multiplexer control signal and the second de-multiplexer control signal is 90 degrees. In some examples, this may enable to de-interleave various input signals comprised in the third output signal as obtained to the disclosure.

In some examples, a switch frequency of the first analog de-multiplexer and the second analog de-multiplexer for switching between respective outputs is equal to or greater than a symbol rate of first and second input signals associated with the modulated signal.

In some examples, the apparatus comprises a clock recovery unit configured to recover a clock signal associated with the modulated signal and to provide, based on the recovered clock signal, at least one of a) the first de-multiplexer control signal, or b) the second de-multiplexer control signal.

In some examples, the apparatus comprises a photodetector configured to convert a modulated optical signal into the modulated signal. In some examples, this enables to transform the modulated optical signal into the electrical domain, e.g., for processing by means of the first and second analog de-multiplexers according to the disclosure.

In some examples, the first analog de-multiplexer and the second analog de-multiplexer is an 1:M de-multiplexer, respectively, wherein M is equal to or greater than 2, wherein the apparatus is configured to time de-interleave 2*M many input signals from the modulated signal.

Some examples relate to a method for an apparatus comprising a first analog de-multiplexer, a second analog de-multiplexer, e.g., for an apparatus according to the disclosure, comprising: providing, by means of the first analog de-multiplexer, based on a first de-multiplexer control signal, a respective portion of a modulated signal at a respective output of the first analog de-multiplexer, providing, by means of the second analog de-multiplexer, based on a second de-multiplexer control signal, a respective portion of the modulated signal at a respective output of the second analog de-multiplexer.

Some examples relate to an apparatus comprising means for: providing, based on a first de-multiplexer control signal, a respective portion of a modulated signal at a respective output of a first analog de-multiplexer, providing, based on a second de-multiplexer control signal, a respective portion of the modulated signal at a respective output of a second analog de-multiplexer.

Some examples relate to a receiver comprising at least one apparatus according to the disclosure. In some examples, the receiver may be an optical receiver or a radio, e.g., radio frequency, receiver.

Some examples relate to a transceiver comprising at least one transmitter according to the disclosure and at least one receiver according to the disclosure.

Some examples relate to a system comprising at least one of: a) an apparatus according to the disclosure, or b) a transmitter according to the disclosure, or c) a receiver according to the disclosure, or d) a transceiver according to the disclosure.

### Brief Description of the Figures

- Fig. 1: schematically depicts a simplified block diagram according to some examples,
- Fig. 2: schematically depicts a simplified block diagram according to some examples,
- Fig. 3: schematically depicts a simplified flow chart according to some examples,
- Fig. 4: schematically depicts a simplified flow chart according to some examples,
- Fig. 5: schematically depicts a simplified flow chart according to some examples,
- Fig. 6: schematically depicts a simplified flow chart according to some examples,
- Fig. 7: schematically depicts a simplified flow chart according to some examples,
- Fig. 8: schematically depicts a simplified flow chart according to some examples,
- Fig. 9: schematically depicts a simplified block diagram according to some examples,
- Fig. 10: schematically depicts a simplified flow chart according to some examples,
- Fig. 11: schematically depicts a simplified flow chart according to some examples,
- Fig. 12: schematically depicts a simplified flow chart according to some examples,
- Fig. 13: schematically depicts a simplified block diagram according to some examples,
- Fig. 14: schematically depicts a simplified block diagram according to some examples.

### Description of some Example Embodiments

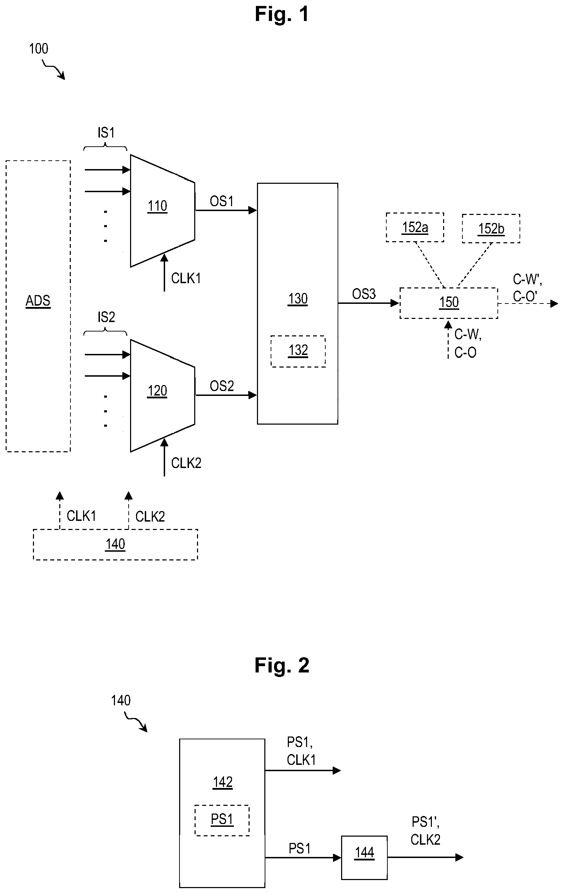

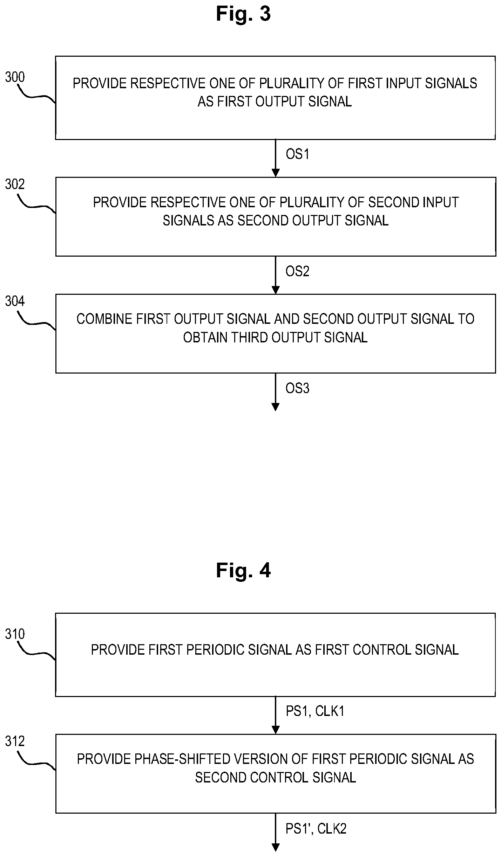

Some examples, see, for example, Fig. 1, 3, relate to an apparatus, e.g., an electric apparatus, 100, comprising a first analog multiplexer 110 configured to provide 300 (Fig. 3) a respective one of a plurality IS1 (Fig. 1) of first input signals as a first output signal OS1, e.g., of the first analog multiplexer 110, based on a first control signal CLK1, a second analog multiplexer 120 configured to provide 302 a respective one of a plurality IS2 of second input signals as a second output signal OS2, e.g., of the second analog multiplexer 120, signal based on a second control signal CLK2, and a combiner 130 configured to combine 304, e.g., add, the first output signal OS1 and the second output signal OS2 to obtain a third output signal OS3. In some examples, this enables to, e.g., efficiently, aggregate, e.g., interleave, e.g., time interleave, a plurality of input signals IS1, IS2, which may, e.g., collectively be characterized by the third output signal OS3.

In some examples, Fig. 1, at least one of the first or second analog multiplexer 110, 120 is configured to receive a plurality IS1, IS2 of analog electrical input signals, e.g., at different inputs or input ports (not shown), and to provide one of the plurality of analog electrical input signals, e.g., at a time, at an output of the analog multiplexer, see, for example, the output signals OS1, OS2. In some examples, thus, an analog multiplexer 110, 120 can be considered to connect, e.g., switch, a respective input port to its output port, e.g., based on a respective control signal CLK1, CLK2. In some examples, a switch frequency, which determines a rate for switching different respective input ports to the output port, e.g., one after the other, may be determined by the respective control signal CLK1, CLK2 for the analog multiplexer 110, 120.

In some examples, a round-robin scheme may be employed to control a sequence for the switching of input ports to the output port of an analog multiplexer 110, 120.

In some examples, Fig. 1, an analog electrical input signal, e.g., forming part of the plurality IS1, IS2, is an electrical signal which is continuous at least with respect to a) time, or b) its amplitude. In some examples, an analog electrical input signal may, e.g., be obtained at an output of a digital-to-analog converter. In some examples, an analog electrical input signal may characterize a sequence of data symbols, e.g., being associate with a symbol rate.

In some examples, Fig. 1, an optional analog data source ADS may be provided, which is configured to provide at least one of a) the first input signals IS1, or b) the second input signals IS2. In some examples, the analog data source ADS may, e.g., comprise a plurality of digital-to-analog converters (not shown) or digital signal processing components.

In some examples, Fig. 1, 2, 4, the apparatus 100 comprises a signal source 140 configured to provide 310 (Fig. 4) a first periodic (e.g., electrical) signal PS1 as the first control signal CLK1 and to provide 312 a phase-shifted version PS1' of the first periodic signal PS1 as the second control signal CLK2. In some examples, this enables to interleave, e.g., time interleave, the output signals OS1, OS2 of the first analog multiplexer 110 and the second analog multiplexer 120.

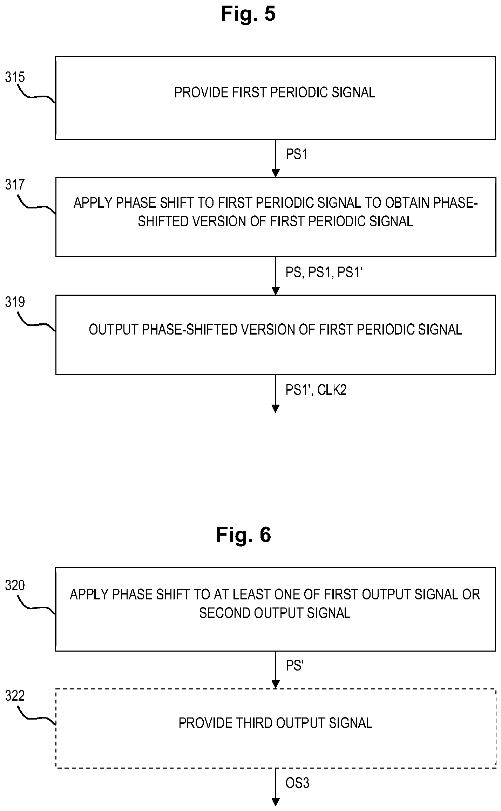

In some examples, Fig. 2, 5, the apparatus 100 comprises an oscillator, e.g., local oscillator, 142 configured to provide 315 (Fig. 5) the first periodic signal PS1, and a phase shifter 144 configured to apply 317 a phase shift PS to the first periodic signal PS1 to obtain the phase-shifted version PS1' of the first periodic signal PS1, and to output 319 the phase-shifted version PS1' of the first periodic signal PS1.

In some examples, Fig. 1, 2, the signal source 140 may comprise at least one of the oscillator 142 or the phase shifter 144.

In some examples, Fig. 1, 6, the combiner 130 comprises a phase shifter 132 configured to apply 320 a phase shift PS' to at least one of the first output signal OS1 or the second output signal OS2, e.g., prior to the combining 304 (Fig. 3). Thus, in some examples, the analog multiplexers 110, 120 may, for example, be controlled with a same, e.g., single, control signal PS1, and a phase shifting enabling to interleave the first and second output signals OS1, OS2 of the analog multiplexers 110, 120 may be effected by the phase shifter 132 of the combiner 130. The optional block 322 of Fig. 6 symbolizes providing the third output signal, e.g., by combining the signals OS1, OS2 or at least one phase shifted component of at least one of OS1, OS2 with the respective other one of OS1, OS2.

In some examples, Fig. 1, a phase shift between the first control signal CLK1 and the second control signal CLK2 is 90 degrees.

In some examples, Fig. 1, a switch frequency of the first analog multiplexer 110 and the second analog multiplexer 120 for switching between respective ones of the plurality IS1 of first input signals or the plurality IS2 of second input signals is equal to or greater than a symbol rate of the first input signals or the second input signals. In some examples, this enables to effectively increase, e.g., double, a symbol rate at a respective output of the analog multiplexers 110, 120.

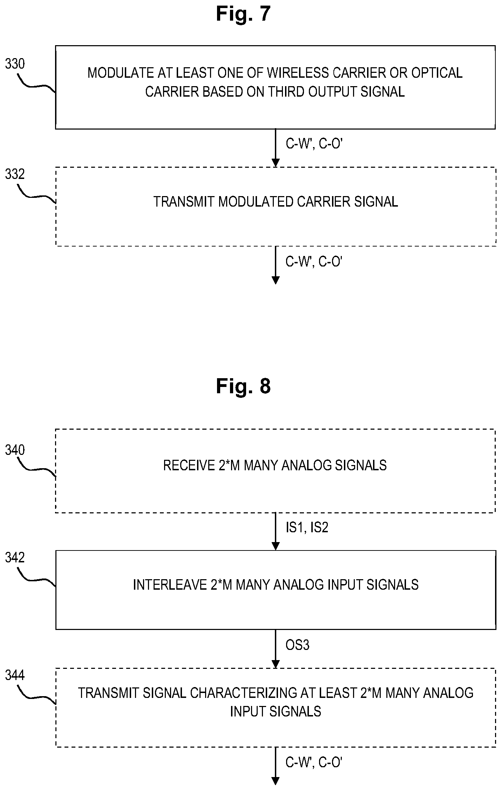

In some examples, Fig. 1, 7, the apparatus 100 comprises a modulator stage 150 configured to modulate 330, based on the third output signal OS3, at least one of: a) a wireless carrier C-W, e.g., a radio frequency signal, or b) an optical carrier C-O, e.g., an optical signal such as, e.g., provided by a laser (not shown). Thus, in some examples, a modulated wireless carrier signal C-W' or a modulated optical carrier signal C-O' may be obtained. The optional block 332 of Fig. 7 symbolizes a transmission of the so obtained modulated carrier signal C-W', CO', e.g., via a suitable transmission medium (e.g., comprising at least one of, but not limited to: optical fiber or free space or waveguide).

In some examples, Fig. 1, the modulator stage 150 comprises at least one of: a) a directly modulated laser 152a (e.g., which may directly be modulated using the third output signal OS3), or b) a Mach-Zehnder modulator 152b.

In some examples, Fig. 1, at least one of a) the first analog multiplexer 110, or b) the second analog multiplexer 120 is an M:1 multiplexer, wherein M is equal to or greater than 2. In other words, in some examples, at least one of a) the first analog multiplexer 110, or b) the second analog multiplexer 120 may comprise M many inputs, e.g., input ports, which may, e.g., selectively, be connected, e.g. switched, to the output port of the respective analog multiplexer 110, 120, e.g., as controlled by a respective first or second control signal CLK1, CLK2.

In some examples, Fig. 1, 8, the apparatus 100 is configured to time interleave, see block 342 of Fig. 8, 2*M many input signals, wherein M characterizes a respective number of inputs of the first analog multiplexer 110 and the second analog multiplexer 120. Hence, in some examples, M many I/Q-modulated analog input signals, each comprising an in-phase (e.g., "I"-) component and a quadrature phase (e.g., "Q"-) component, may be interleaved using the apparatus 100 according to the disclosure, e.g., to form the third output signal OS3. The optional block 344 of Fig. 8 symbolizes transmitting a signal characterizing at least the 2*M many analog input signals, e.g., using a suitable carrier signal, as exemplarily disclosed above with respect to Fig. 7, blocks 330, 332. The optional block 340 of Fig. 8 symbolizes receiving the 2*M many input signals IS1, IS2, e.g., 2*M many analog input signals, e.g., from an analog data source ADS (Fig. 1).

Some examples, Fig. 3, relate to a method for an apparatus 100 comprising a first analog multiplexer 110 (Fig. 1), a second analog multiplexer 120, and a combiner 130, e.g., for an apparatus 100 according to the disclosure, the method comprising: providing 300 (Fig. 3), by means of the first analog multiplexer 110, a respective one of a plurality IS1 of first input signals as a first output signal OS1 based on a first control signal CLK1, providing 302, by means of the second analog multiplexer 120, a respective one of a plurality IS2 of second input signals as a second output signal OS2 based on a second control signal CLK2, combining 304, by means of the combiner 130 (Fig. 1), the first output signal OS1 and the second output signal OS2 to obtain the third output signal OS3.

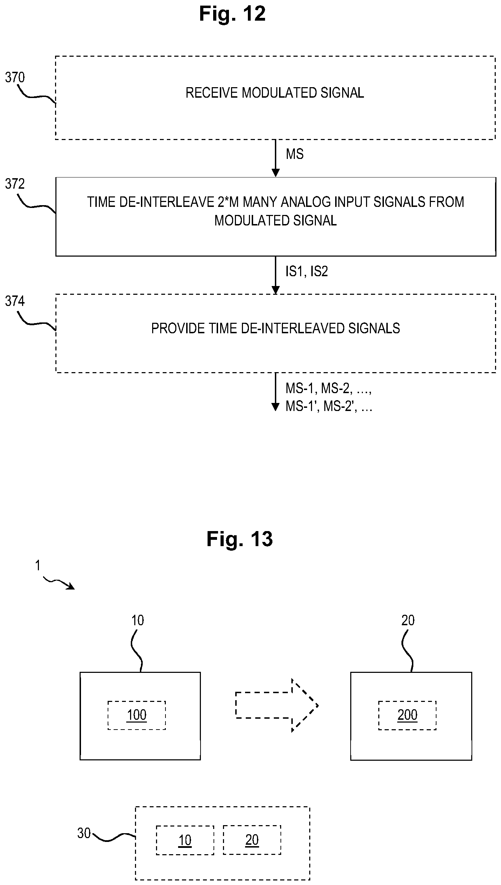

Some examples, Fig. 13, relate to a transmitter 10 comprising at least one apparatus 100 according to the disclosure. In some examples, the transmitter 10 may be an optical transmitter, e.g., configured to transmit at least one modulated optical signal, see the dashed block arrow of Fig. 13. In some examples, the transmitter 10 may be a radio transmitter, e.g., configured to transmit at least one modulated radio signal, e.g., in a radio frequency range.

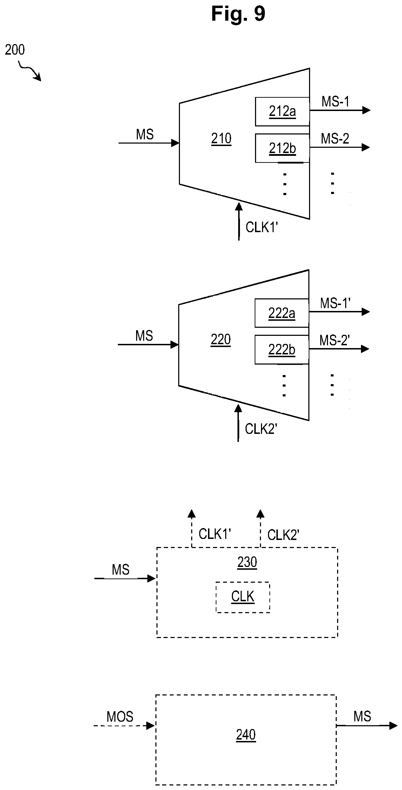

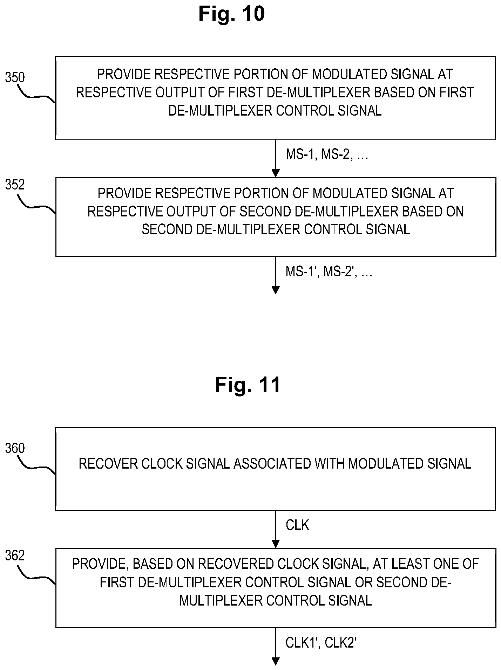

Some examples, Fig. 9, 10, relate to an apparatus 200 comprising a first analog de-multiplexer 210 configured to provide 350, based on a first de-multiplexer control signal CLK1', a respective portion MS-1, MS-2, ... of a modulated signal MS at a respective output 212a, 212b, ... of the first analog de-multiplexer 210, a second analog de-multiplexer 220 configured to provide 352, based on a second de-multiplexer control signal CLK2', a respective portion MS-1', MS-2', ... of the modulated signal MS at a respective output 222a, 222b, ... of the second analog de-multiplexer 220.

In some examples, Fig. 9, the modulated signal MS may, e.g., be the third output signal OS3 (Fig. 1) as provided by the apparatus 100 according to the disclosure or a signal derived from the third output signal OS3.

In some examples, Fig. 9, a phase shift between the first de-multiplexer control signal CLK1' and the second de-multiplexer control signal CLK2' is 90 degrees, e.g., similar to the signals CLK1, CLK2 for the apparatus 100 (Fig. 1). In some examples, this may enable to de-interleave various input signals IS1, IS2 comprised in the third output signal OS3, e.g., the modulated signal MS, as obtained to the disclosure.

In some examples, Fig. 9, a switch frequency of the first analog de-multiplexer 210 and the second analog de-multiplexer 220 for switching between respective outputs 212a, 212b, ... or 222a, 222b, ... is equal to or greater than a symbol rate of first and second input signals IS1, IS2 associated with the modulated signal MS.

In some examples, Fig. 9, 11, the apparatus 200 comprises a clock recovery unit 230 configured to recover 360 a clock signal CLK associated with (e.g., used to provide) the modulated signal MS and to provide 362, based on the recovered clock signal CLK, at least one of a) the first de-multiplexer control signal CLK1', or b) the second de-multiplexer control signal CLK2'. In some examples, the recovered clock signal CLK may, e.g., be used as the first de-multiplexer control signal CLK1', and the second de-multiplexer control signal CLK2' may be derived from the signal CLK or CLK1', e.g., by applying a phase shift of, e.g., 90 degrees.

In some examples, Fig. 9, the apparatus 200 comprises a photodetector 240 configured to convert a modulated optical signal MOS into the modulated signal MS. In some examples, this enables to transform the modulated optical signal MOS into the electrical domain, e.g., for processing by means of the first and second analog de-multiplexers 210, 220 according to the disclosure. In some examples, Fig. 9, the modulated optical signal MOS may, e.g., correspond with the modulated optical carrier signal C-O', or a received version of the modulated optical carrier signal C-O' as transmitted via an optical transmission medium (not shown), e.g., by a transmitter 10 (Fig. 13) according to the disclosure.

In some examples, Fig. 9, 12, the first analog de-multiplexer 210 and the second analog de-multiplexer 220 is an 1:M de-multiplexer (e.g., a de-multiplexer having M many outputs), respectively, wherein M is equal to or greater than 2, wherein the apparatus 200 is configured to time de-interleave, see block 372 of Fig. 12, 2*M many input signals from the modulated signal MS.

The optional block 370 of Fig. 12 symbolizes receiving a modulated signal MS, e.g., the third output signal OS3 or a signal derived therefrom (e.g., transmitted and received signal, wherein the transmitted signal has been obtained based on the third output signal OS3, e.g., by modulating a carrier signal).

The optional block 374 of Fig. 12 symbolizes providing the time de-interleaved signals MS-1, MS-2, ..., MS-1', MS-2', ..., as, e.g., obtained by block 372.

Some examples, Fig. 10, relate to a method for an apparatus 200 comprising a first analog de-multiplexer 210, a second analog de-multiplexer 220, e.g., for an apparatus 200 according to the disclosure, comprising: providing 350, by means of the first analog de-multiplexer, based on a first de-multiplexer control signal, a respective portion of a modulated signal at a respective output of the first analog de-multiplexer, providing 352, by means of the second analog de-multiplexer, based on a second de-multiplexer control signal, a respective portion of the modulated signal at a respective output of the second analog de-multiplexer.

Some examples, Fig. 13, relate to a receiver 20 comprising at least one apparatus 200 according to the disclosure. In some examples, the receiver 20 may be an optical receiver or a radio receiver.

Some examples, Fig. 13, relate to a transceiver 30 comprising at least one transmitter 10 according to the disclosure and at least one receiver 20 according to the disclosure.

Some examples, Fig. 13, relate to a system 1 comprising at least one of: a) an apparatus 100, 200 according to the disclosure, or b) a transmitter 10 according to the disclosure, or c) a receiver 20 according to the disclosure, or d) a transceiver 30 according to the disclosure.

In the following, further aspects and examples are disclosed, which, in some examples, may be combined with at least one of the aspects and/or examples disclosed above.

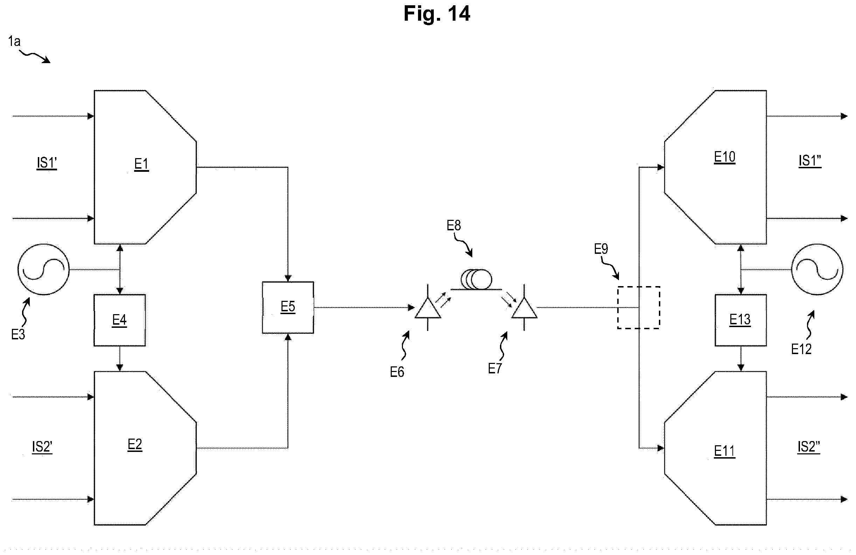

Fig. 14 schematically depicts a simplified block diagram of a system 1a according to some examples. Element E1 symbolizes a first analog multiplexer, e.g., at least similar to element 110 of Fig. 1, element E2 of Fig. 14 symbolizes a second analog multiplexer, e.g., at least similar to element 120 of Fig. 1. Element E3 symbolizes a clock source, e.g., local oscillator, providing a first control signal to the first analog multiplexer E1. Element E4 symbolizes a phase shifter providing a, for example 90 degree phase shifted, first control signal to the second analog multiplexer E2. Element IS1' symbolizes a plurality of analog input signals provided to respective inputs (not shown) of the first analog multiplexer E1, and element IS2' symbolizes a plurality of analog input signals provided to respective inputs (not shown) of the second analog multiplexer E2. Respective output signals of the analog multiplexers E1, E2 may be combined, e.g., added, by combiner or adder E5, to obtain the third output signal OS3 (Fig. 1) at an output of the combiner E5.

Element E6 of Fig. 14 symbolizes a modulation of an optical carrier signal using the output signal of the combiner E5, and element E7 of Fig. 17 symbolizes a photodetector for transforming a received modulated optical signal into the electrical domain, e.g., to obtain an electrical modulated signal, e.g., at least similar to signal MS of Fig. 9.

In some examples, a modulated optical signal as obtained by the modulation E6 may be transmitted via a suitable transmission medium, presently, for example, at least one optical fiber E8, e.g., to the photodetector E7.

Element E9 of Fig. 14 symbolizes an optional splitter, e.g., 3dB splitter, which provides respective portions of the electrical modulated signal as obtained by the photodetector E7 to the analog de-multiplexers E10, E11, e.g., for de-interleaving, e.g., in accordance with at least one control signal as may be provided by a local signal source E12, e.g., a local oscillator, and, optionally, by a phase shifter E13. In other words, in some examples, the analog de-multiplexers E10, E11 may be controlled by two control signals comprising a relative phase shift of, e.g., 90 degrees, e.g., as also provided on a transmitter side by the phase shifter E4, e.g., for controlling an operation of the analog multiplexers E1, E2.

Elements IS1", IS2" symbolize de-interleaved analog signals as obtained by the analog de-multiplexers E10, E11 in accordance with aspects of the disclosure, based on the electrical modulated signal as provided by the photodetector E7.

In some examples, the system 1a of Fig. 14 enables to provide a, for example coherent, modulation and demodulation, e.g., for optical data links E8.

In some examples, Fig. 13, using the principle according to the disclosure, optical transceivers 30 may be provided which are comparatively compact and cost efficient.

In some examples, Fig. 14, e.g., two pairs of data channels, e.g. "I1", "Q1" and "I2", "Q2", may be processed, e.g., parallelized, using the analog multiplexers E1, E2, e.g., with clock phase shifts of 90 degrees with regard to each other (see elements E3, E4), and corresponding output signals of the analog multiplexers E1, E2 may be added by element E5, thus forming a modulated output signal. In some examples, element IS1' of Fig. 14 collectively denotes the data channels "I1" and "I2", while element IS2' of Fig. 14 collectively denotes the data channels "Q1" and "Q2".

In some examples, Fig. 14, e.g., on a receiver side, a modulated signal or data stream, as, e.g., provided by the photodetector E7, may be split into two streams, using the splitter E9, and a "demodulation", e.g., de-interleaving, may be performed by the two analog de-multiplexers E10, E11, e.g., using a same clock frequency (see local oscillator E12) and phase shift (see phase shifter E13) of 90 degrees as the components E3, E4 on the transmitter side. In some examples, the output signals IS1", IS2" that may be obtained at the outputs of the analog de-multiplexers E10, E11 may represent two pairs of data channels that represent in-phase data signals "I1", "I2" and out-of (e.g., quadrature)-phase data signals "Q1", "Q2). In some examples, element IS1" of Fig. 14 collectively denotes the signals "I1" and "I2", while element IS2" of Fig. 14 collectively denotes the signals "Q1" and "Q2".

In some examples, at least some of the analog multiplexers E1, E2 or the analog de-multiplexers E10, E11 may be used, e.g., act, as symbol rate doublers, e.g., with regard to analog input signals or input data channels and, e.g., broadband frequency mixers in a baseband.

In some examples, at least some of the analog multiplexers E1, E2 or the analog de-multiplexers E10, E11 may use two phases of a clock signal PS1, e.g., with a phase difference of, e.g., 180 degrees (e.g., the analog multiplexers E1, E2 may be clocked in "counter phase"), e.g., to switch between different input channels or signals.

In some examples, when a switch frequency of the analog multiplexers E1, E2 equals a symbol rate of the input signals, e.g., associated with the data channels, an effective symbol rate, e.g., as seen at an output of the analog multiplexers E1, E2 or at an input of the analog de-multiplexers E10, E11, may be doubled.

As mentioned above, a clock signal, which can e.g. be used as a control signal for at least one of the elements E1, E2, E10, E11, may be provided by a respective local oscillator E3, E12.

In some examples, such local oscillator E3, E12 may, e.g., form a part of a synchronization loop, such as a PLL (phase-locked loop) or DLL (delay-locked loop), and may, e.g., comprise several stages of frequency dividers or multipliers.

In some examples, however, e.g., in the case of using a two-channel, e.g., 2:1 analog multiplexer E1 and a two-channel, e.g., 1:2, analog de-multiplexer E10, since these components E1, E10 "only" use two phases of a clock signal or respective control signal, e.g., separated by 180 degrees, in some examples, a second analog multiplexer E2 and a corresponding second analog de-multiplexer E11 may be provided, with their control signal, e.g., as based on a respective local oscillator E3, E12, being offset by 90 degrees with regard to the control signal of the first device(s) E1, E10.

In some examples, adding the output signals of the analog multiplexers E1, E2, e.g., on the transmitter side, or splitting the signal as provided, e.g., by the photodetector E7, in two signal portions, may represent a coherent modulation technique.

As mentioned above, in some examples, Fig. 14, the combined output signal of element E5 may be modulated onto a carrier or carrier signal, such as, e.g., a wireless (e.g., radio frequency) carrier, or an optical carrier.

In some examples, at least one of the analog multiplexers 110, 120, E1, E2 or of the analog de-multiplexers 210, 220, E10, E11 may be configured to handle signals with symbol rates of, e.g., 100 GBd (Gigabaud) or higher.

In some examples, when applying the principle of the disclosure to optical transmitters or receivers or transceivers, at least one Mach-Zehnder (e.g., optical) modulator and at least one optical 90 degrees phase shifter, e.g., on the transmitter side, as well as an optical local oscillator and an optical 90 degrees hybrid, e.g., on the receiver side, may be saved, thus reducing complexity and costs, as compared to conventional approaches with optical modulators and demodulators.

In some examples, when using the principle according to the disclosure, there is no need to lock, e.g., a second optical local oscillator (e.g., on the receiver side) with a local oscillator on the transmitter side, e.g., to achieve a stable time base. Rather, in some examples, a receiver-side (e.g., electrical) local oscillator may, e.g., be a recovered clock, e.g., from the received data stream, e.g., as may be obtained in some examples by means of a clock recovery or a clock and data recovery.

In some examples, e.g., compared with a conventional optical IM/DD (intensity modulation/direct detection) link, the approach according to the disclosure may, e.g., double a transmitted symbol rate, e.g., by an electronic coherent modulation as may be effected by using the electronic analog multiplexers 110, 120.

In some examples, Fig. 13, e.g., when using an optical transmitter 10 or receiver 20 or transceiver 30, multiple polarizations and/or optical wavelengths (e.g., wavelength channels) may be used, e.g., in combination with the principle according to the disclosure.

In other words, in some examples, one apparatus 100 according to, e.g., Fig. 1, may be used to provide a third output signal OS3 for modulating, e.g., a first optical carrier associated with a first specific optical wavelength or wavelength channel, and at least one further apparatus 100 may be used to provide a further "third", e.g., combined, output signal of two analog multiplexers 110, 120, e.g., for modulating, e.g., a second optical carrier associated with a second specific optical wavelength or wavelength channel, and the like. In some examples, a similar principle may also be applied to different optical polarizations.

In some embodiments, Fig. 1, at least some of the following components may, e.g., be combined, e.g., to form one, e.g., single, electrical circuit: a) first analog multiplexer 110, or b) second analog multiplexer 110, or c) combiner, or d) signal source 140, or e) oscillator 142, or f) phase shifter 144, or g) phase shifter 132.

In some examples, Fig. 1, the apparatus 100 may be combined, e.g., integrated with, the optional analog data source ADS or at least one digital signal processor or at least one digital-to-analog converter associated with the analog data source ADS.

In some examples, Fig. 9, similar degrees of integration or modularity as mentioned above with respect to the transmitter side components 110, 120, 130, 140, ... may be applied to at least some components 210, 220, 230, 240 associated with a receiver side.

In some examples, Fig. 1, at least one of the components 110, 120, 130, 140, ... may be provided as an individual, e.g., integrated, circuit.

In some examples, the principle according to the disclosure may, e.g., be used for, e.g., highspeed, coherent optical transceivers 30 (Fig. 13), which, in some cases, may be either bandwidth-limited, e.g., by digital signal processing components, e.g., as currently available, or which, e.g., may require a more compact footprint.

In some examples, the principle according to the disclosure may, e.g., be used to increase, e.g., double, a symbol rate, e.g., in IM/DD-transceivers, e.g., for data centers.

In some examples, the principle according to the disclosure enables to realize a coherent modulation/demodulation in the electrical or electronic domain (e.g., as opposed to the optical domain), which, in some examples, may contribute to reducing a need for optical components, e.g., directly translating to smaller footprints and potentially reducing size and cost of, e.g., optical transceivers 30.

In some examples, the principle according to the disclosure enables to increase a cost efficiency of optical data links.

Embodiments 1 to 20 defined below are a transcript of claims 1 to 20 of US patent application number 18/436,859 filed on 8 February 2024, the contents of which are incorporated herein by reference.
1. An apparatus comprising a first analog multiplexer configured to provide a respective one of a plurality of first input signals as a first output signal based on a first control signal, a second analog multiplexer configured to provide a respective one of a plurality of second input signals as a second output signal based on a second control signal, and a combiner configured to combine the first output signal and the second output signal to obtain a third output signal.
2. The apparatus according to embodiment 1, comprising a signal source configured to provide a first periodic signal as the first control signal and to provide a phase-shifted version of the first periodic signal as the second control signal.
3. The apparatus according to embodiment 1, comprising an oscillator configured to provide a or the first periodic signal and a phase shifter configured to apply a phase shift to the first periodic signal to obtain a or the phase-shifted version of the first periodic signal, and to output the phase-shifted version of the first periodic signal.
4. The apparatus according to embodiment 1, wherein the combiner comprises a phase shifter configured to apply a phase shift to at least one of the first output signal or the second output signal.
5. The apparatus according to embodiment 1, wherein a phase shift between the first control signal and the second control signal is 90 degrees.
6. The apparatus according to embodiment 1, wherein a switch frequency of the first analog multiplexer and the second analog multiplexer for switching between respective ones of the plurality of first input signals or the plurality of second input signals is equal to or greater than a symbol rate of the first input signals or the second input signals.
7. The apparatus according to embodiment 1, comprising a modulator stage configured to modulate, based on the third output signal, at least one of: a) a wireless carrier, or b) an optical carrier.
8. The apparatus according to embodiment 7, wherein the modulator stage comprises at least one of: a) a directly modulated laser, or b) a Mach-Zehnder modulator.
9. The apparatus according to embodiment 1, wherein at least one of a) the first analog multiplexer, or b) the second analog multiplexer is an M:1 multiplexer, wherein M is equal to or greater than 2.
10. The apparatus according to embodiment 1, wherein the apparatus is configured to time interleave 2*M many input signals, wherein M characterizes a respective number of inputs of the first analog multiplexer and the second analog multiplexer.
11. A method for an apparatus comprising a first analog multiplexer, a second analog multiplexer, and a combiner, the method comprising: providing, by means of the first analog multiplexer, a respective one of a plurality of first input signals as a first output signal based on a first control signal, providing, by means of the second analog multiplexer, a respective one of a plurality of second input signals as a second output signal based on a second control signal, combining, by means of the combiner, the first output signal and the second output signal to obtain a third output signal.
12. A transmitter comprising at least one apparatus according to embodiment 1.
13. An apparatus comprising a first analog de-multiplexer configured to provide, based on a first de-multiplexer control signal, a respective portion of a modulated signal at a respective output of the first analog de-multiplexer, a second analog de-multiplexer configured to provide, based on a second de-multiplexer control signal, a respective portion of the modulated signal at a respective output of the second analog de-multiplexer.
14. The apparatus according to embodiment 13, wherein a phase shift between the first de-multiplexer control signal and the second de-multiplexer control signal is 90 degrees.
15. The apparatus according to embodiment 13, wherein a switch frequency of the first analog de-multiplexer and the second analog de-multiplexer for switching between respective outputs is equal to or greater than a symbol rate of first and second input signals associated with the modulated signal.
16. The apparatus according to embodiment 13, comprising a clock recovery unit configured to recover a clock signal associated with the modulated signal and to provide, based on the recovered clock signal, at least one of a) the first de-multiplexer control signal, or b) the second de-multiplexer control signal.
17. The apparatus according to embodiment 13, comprising a photodetector configured to convert a modulated optical signal into the modulated signal.
18. The apparatus according to embodiment 13, wherein the first analog de-multiplexer and the second analog de-multiplexer is an 1:M de-multiplexer, respectively, wherein M is equal to or greater than 2, wherein the apparatus is configured to time de-interleave 2*M many input signals from the modulated signal.
19. A method for an apparatus comprising a first analog de-multiplexer, a second analog de-multiplexer, comprising: providing, by means of the first analog de-multiplexer, based on a first de-multiplexer control signal, a respective portion of a modulated signal at a respective output of the first analog de-multiplexer, providing, by means of the second analog de-multiplexer, based on a second de-multiplexer control signal, a respective portion of the modulated signal at a respective output of the second analog de-multiplexer.
20. A receiver comprising at least one apparatus according to embodiment 13.

## Claims

1. An apparatus (100) comprising a first analog multiplexer (110) configured to provide a respective one of a plurality (IS1) of first input signals as a first output signal (OS1) based on a first control signal (CLK1), a second analog multiplexer (120) configured to provide (302) a respective one of a plurality (IS2) of second input signals as a second output signal (OS2) based on a second control signal (CLK2), and a combiner (130) configured to combine (304) the first output signal and the second output signal to obtain a third output signal (OS3).

2. The apparatus according to claim 1, comprising a signal source (140) configured to provide (310) a first periodic signal (PS1) as the first control signal (CLK1) and to provide (312) a phase-shifted version (PS1') of the first periodic signal as the second control signal (CLK2).

3. The apparatus according to claim 1, comprising an oscillator (142) configured to provide a or the first periodic signal (PS1) and a phase shifter (144) configured to apply (317) a phase shift (PS) to the first periodic signal to obtain a or the phase-shifted version (PS1') of the first periodic signal, and to output (319) the phase-shifted version of the first periodic signal.

4. The apparatus according to claim 1, wherein the combiner comprises a phase shifter (132) configured to apply (320) a phase shift (PS') to at least one of the first output signal (OS1) or the second output signal (OS2).

5. The apparatus according to claim 1, wherein a phase shift between the first control signal and the second control signal is 90 degrees.

6. The apparatus according to claim 1, wherein a switch frequency of the first analog multiplexer (110) and the second analog multiplexer (120) for switching between respective ones of the plurality of first input signals or the plurality of second input signals is equal to or greater than a symbol rate of the first input signals or the second input signals.

7. The apparatus according to claim 1, comprising a modulator stage (150) configured to modulate, based on the third output signal (OS3), at least one of: a) a wireless carrier, or b) an optical carrier.

8. The apparatus according to claim 1, wherein at least one of a) the first analog multiplexer, or b) the second analog multiplexer is an M:1 multiplexer, wherein M is equal to or greater than 2.

9. The apparatus according to claim 1, wherein the apparatus (100) is configured to time interleave 2*M many input signals, wherein M characterizes a respective number of inputs of the first analog multiplexer (110) and the second analog multiplexer (120).

10. An apparatus (200) comprising a first analog de-multiplexer (210) configured to provide (350), based on a first de-multiplexer control signal (CLK1'), a respective portion (MS-1, MS-2) of a modulated signal (MS) at a respective output (212a, 212b) of the first analog de-multiplexer (210), a second analog de-multiplexer (220) configured to provide (352), based on a second de-multiplexer control signal (CLK2'), a respective portion (MS-1, MS-2) of the modulated signal (MS) at a respective output (222a, 222b) of the second analog de-multiplexer.

11. The apparatus according to claim 10, wherein a phase shift between the first de-multiplexer control signal and the second de-multiplexer control signal is 90 degrees.

12. The apparatus according to claim 10, wherein a switch frequency of the first analog de-multiplexer and the second analog de-multiplexer for switching between respective outputs is equal to or greater than a symbol rate of first and second input signals associated with the modulated signal.

13. The apparatus according to claim 10, comprising a clock recovery unit (230) configured to recover (360) a clock signal (CLK) associated with the modulated signal (MS) and to provide, based on the recovered clock signal, at least one of a) the first de-multiplexer control signal, or b) the second de-multiplexer control signal.

14. The apparatus according to claim 10, comprising a photodetector (240) configured to convert a modulated optical signal (MOS) into the modulated signal (MS).

15. The apparatus according to claim 10, wherein the first analog de-multiplexer (210) and the second analog de-multiplexer (220) is a 1:M de-multiplexer, respectively, wherein M is equal to or greater than 2, wherein the apparatus (200) is configured to time de-interleave (372) 2*M many input signals from the modulated signal (MS).
